# EUROPEAN PATENT SPECIFICATION

(11) **EP 0 688 102 B1**
(45) Date of publication and mention of the grant of the patent: **28.07.1999**
(21) Application number: 94108833.8
(22) Date of filing: 09.06.1994
(51) Int. Cl.: H03K 17/96

(54) **Finger-touch radiofrequency control device for household electrical appliances, such as ovens, cooking hobs, cookers, washing machines, dishwashers and the like**
Radiofrequente Fingertasten Steuervorrichtung für Öfen, Kochmulden, Kocher, Waschmaschinen, Geschirrspüler, od.dgl.
Dispositif de commande comportant une touche tactile à haute fréquence pour des appareils électroménagers comme des fours, des plaques de cuisson, machines à laver, lave-vaisselle, ou similaire

(43) Date of publication of application: 20.12.1995
(73) Proprietor: WHIRLPOOL EUROPE B.V., 5507 SK Veldhoven (NL)
(72) Inventor: Frasnetti, Luca, c/o Whirlpool Italia s.r.l., I-21025 Comerio (VA) (IT)
(74) Representative: Guerci, Alessandro

(56) References cited:
- EP-A- 0 150 421
- EP-A- 0 443 924
- EP-A- 0 603 039
- FR-A- 2 295 644
- FR-A- 2 343 371
- US-A- 3 877 029
- US-A- 4 290 052

## Description

This invention relates in general to a device for controlling the operation of one or more elements of household electrical appliances. More particularly, but not limitatively, the device can be used for controlling the heating power provided by those electrical heating elements, in general electrical resistance elements, halogen lamps or the like, provided in food cooking appliances, such as ovens, cooking hobs, cookers and the like.

The device of the invention is of the type in which the simple application of a user's finger at predetermined points enables the operation of the appliance elements to be controlled.

Devices are known for controlling for example the functional heating elements of household electrical appliances by the simple application of a finger at suitable points on the appliance.

These devices are based on capacitive, conductive, optical, ultrasound, extensometric and other methods, and suffer from drawbacks inherent in the method used.

US-A-3 877 029 discloses a radiation-sensitive electronic keyboard having individual, square surfaces of conventional conductive material applied on an insulating substrate.

The main object of the present invention is to provide a finger-touch or finger-application control device based on a new applicational method such as to result in lower construction costs and considerable reliability in its results.

A further object of the present invention is to provide a finger-touch or finger-application control device of simple and low-cost implementation.

These and further objects which will be more apparent from the detailed description given hereinafter are attained by a device in accordance with the accompanying claims.

Basically, the invention senses the presence of the finger resting on a predetermined point by the influence which the finger exerts on the behaviour of the antenna circuit of a receiver which, on the basis of this, feeds control signals to a circuit controlling the desired appliance functional elements, for example resistance elements.

The invention will be more apparent from the detailed description of preferred embodiments thereof given hereinafter by way of non-limiting example with reference to the accompanying drawing, in which:
Figure 1 is a schematic perspective view from below of a glass ceramic cooking hob, showing the block diagram of a first embodiment of the device of the invention, and the functional heating elements controlled by said device;
Figure 1A shows a circuit aspect of a different embodiment which uses a single receiver, but associated with a multiplexer for independently controlling several functional elements;
Figure 2 schematically shows a different location of the radiofrequency transmitter relative to the position of the receiver or receivers;
Figure 3 shows a possible electrical schematic for the receiver;
Figure 4 is a schematic perspective view of a detail relative to an arrangement of the antennas (both receiving and transmitting) on insulating bases;
Figure 4A is a schematic partial longitudinal section through that shown in Figure 4;
Figures 5 and 6 are perspective views of two household electrical appliances incorporating the device of the invention.

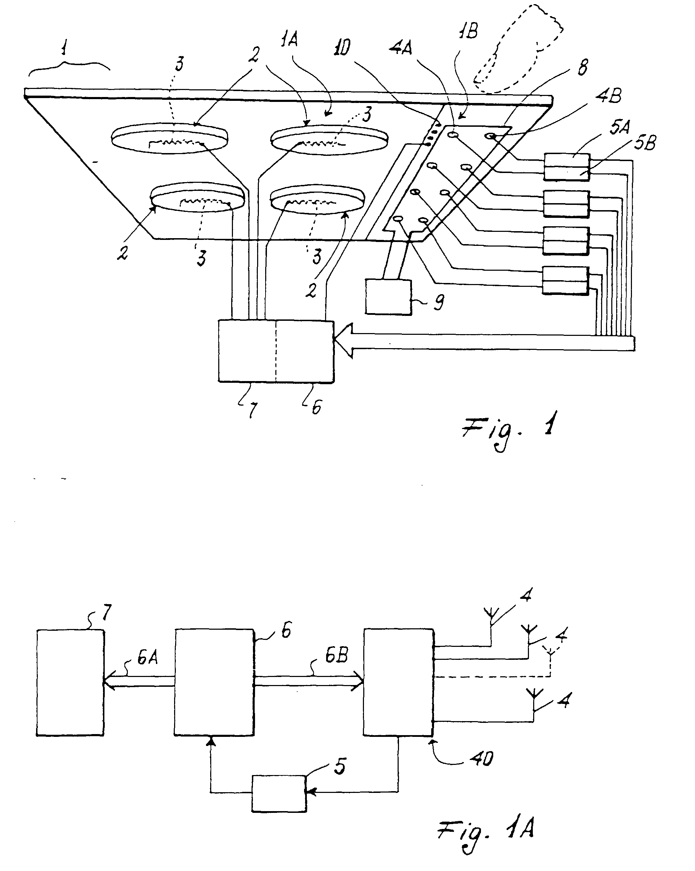

Figure 1, relative to a first embodiment of the invention, schematically represents a conventional cooking hob, ie comprising a hob plate formed from a glass ceramic plate 1 (hence of non-conducting material), and a frame, not shown, carrying this plate and supporting substantially cylindrical sheet metal housings 2 in which functional heating elements 3 such as electrical resistance elements or halogen lamps are mounted.

In this embodiment of the invention, two regions indicated respectively by 1A and 1B can be identified, the region 1A being known as the "cooking region" in which the heating elements 3 with their housings 2 are positioned, and the region 1B being known as the "control region" in which the means of the invention, described in detail hereinafter, are positioned for controlling the heating elements 3.

Saucepans and the like are rested on the upper face of the cooking region 1A to be heated by the heating elements 3 which can be positioned below the glass ceramic plate to each involve a predetermined part of said region.

Although this embodiment relates to the application of the invention to a cooking hob with a glass ceramic plate, it will be apparent from the ensuing description that whereas the cooking region can be of any material chosen in accordance with requirements, the material of the control region must be electrically non-conductive.

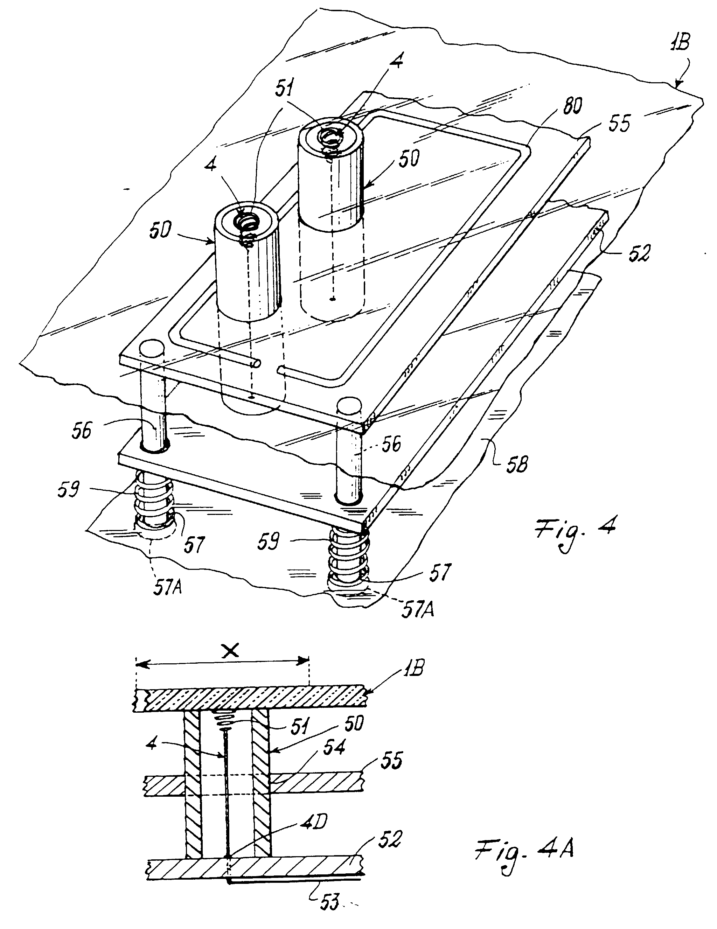

A number of pairs of receiving antennas 4A, 4B equal to the number of heating elements 3 are positioned in contact with the lower face of the control region 1B. In the illustrated embodiment, which comprises four heating elements 3, there are consequently four pairs of receiving antennas. These receiving antennas can consist of metal wire which at its free end terminates as a spiral or as a helical spring (this latter arrangement is shown in Figures 4, 4A).

These antennas rise from the insulating board of a printed circuit, with which they are rigid by being soldered to a conducting strip thereof leading to a radiofrequency receiver 5A, 5B, the components of which are mounted on said board and interconnected by suitable conductive strips. The board is supported by the frame, not shown, which carries both the cooking hob and the heating elements.

Only one pair of antennas 4A, 4B will be considered, one for controlling the increase and the other for controlling the decrease in the heating power of a single element 3. Extension to the other elements is achieved by simply repeating the single control.

Each of the receiving antennas 4A, 4B of the considered pair is connected to a separate radiofrequency receiver 5A, 5B. The two receivers are constructionally identical. A possible but not exclusive receiver is shown in Figure 3.

The radiofrequency receiver 5A, 5B is designed to provide an output voltage dependent on the amplitude of the signal received by the relative antenna.

The radiofrequency receiver, shown only by way of example in Figure 3, comprises with the antenna 4A, 4B a tuned input circuit formed from an inductance L1 and a capacitor C1 connected in parallel. In parallel with these there is a high-ohmic resistor R1. The antenna signal is applied to the gate J1 of an n channel field effect transistor, the source of which is connected to earth via a resistor R2 and capacitor C2 in parallel, the drain being connected to a d.c. voltage source V1 via a resistor R3.

A resistive voltage divider R4, R5 is connected between the voltage source V1 and earth. The dividing point is connected to the base of a transistor Q1 and to a coupling capacitor C5 which is connected to the drain of the FET J1.

The collector of the transistor Q1 is connected to the voltage source V1 via a resistor R7, its emitter being connected to earth via a resistor R6 and capacitor C3 in parallel. The transistor collector is connected to the output Vout via a diode D1. A capacitor C4 and resistor R8 are connected in parallel between the output and earth.

The output signals from the two receivers are fed to a microprocessor 6 the purpose of which is to interpret the output voltage variations of the receivers so as to modify the power level of the heating elements 3 on the basis of user requirements, via a conventional interface 7.

At the lower face of the control region 1B of the plate 1 there is provided a transmitting antenna 8. In Figure 1 the antenna shown is substantially in the form of a loop and can be obtained by silk-screen printing on the lower face of the control region 1B of the plate. Both the shape and position of this antenna can however be different. The transmitting antenna can be formed by a conductive strip other than annular provided on a printed circuit board which can be the same one on which the receivers 5A and 5B are located and the receiving antennas 4A and 4B are fixed, or on a base which can be different from but associated with this latter base.

In the embodiment of Figure 1 the receiving antenna, which will be assumed to be applied (by silk-screen printing) to the control region 1B, bounds the area within which all the receiving antennas 4A, 4B are applied. The antenna 8 is connected to a conventional radiofrequency transmitter 9, consisting of a simple oscillator of known type (Colpitts, astable, quartz etc.).

Under rest conditions, ie when the user is not using the cooking hob, but the receiver and transmitter are active, the output voltage of the receivers 5A, 5B, which is a function of the amplitude of the received signal, is stabilized at a value indicated as VSTAB.

When the user's finger (Figure 1) is applied to that area of the control region 1B lying above one of the two antennas 4A, 4B, namely that used for activating the appropriate resistance element 3 and controlling its heating power, which will be assumed to be 4A and will be indicated hereinafter as the "incremental antenna", the field generated by the transmitter 9 is modified such that the amplitude of the signal reaching the receiver 5A (correlated with the antenna 4A) decreases. The application of the user's finger can be considered as the connection of an impedance in parallel with the receiver resonance circuit, this impedance subtracting energy from the field and modifying the resonance frequency of the original resonance circuit. By suitably sizing the receiver components a reduction in the value VSTAB by a quantity VDITO can be achieved on applying the finger. This reduction is a function of the distance of the finger from the area immediately above the receiving antenna and will evidently be a maximum when the finger is exactly centered and applied on this area.

The variation in the output voltage of the receiver 5A (associated with the incremental antenna 4A) is processed by a microprocessor 6 such as to switch on and vary the power of the corresponding heating element 3 via a suitable known interface 7, comprising for example static or electromechanical relays able to vary the duty cycle of the voltage applied to the heating element or modify the connection of parts of the heating element, for example from series to parallel or mixed.

The output signal from the receiver 5B associated with the antenna 4B, which will be known as the "decremental antenna" remains however nearly constant.

By analyzing the variation in the difference between the two output signals from the receivers 5A, 5B, the microprocessor 6 is able to decide which of the two antennas 4A, 4B has been more greatly influenced, ie to decide where the finger has been applied. By knowing where the finger has been applied and knowing the significance of this application, the microprocessor 6 modifies the set power level by incrementing a variable associated with this level.

The power increase can be achieved either by single touches to the sensitive area or by maintaining the finger on it for a given time. These methods of operation are easily achievable by simple control algorithms implemented in the microprocessor, which take account of the number of touches or of the time for which the finger remains on the sensitive area.

The set power can be easily displayed by a series of LEDs 10 or conventional 7-segment display units positioned in the control region 1B below the glass ceramic plate (semi-transparent) and controlled by the microprocessor 6. The number of LEDs lit or the number appearing on the 7-segment display unit indicates the applied power. When the power considered sufficient has been reached, the user removes his finger from the sensitive region with the result that the original Vout output conditions are restored, but without the set power level undergoing any change because the count representing the number of "touches" or the count representing the time for which the finger remains on the antenna, these counts being effected by the microprocessor, remain memorized after the finger has been removed.

When the desired extent of cooking has been achieved, the user places his finger on the sensitive region of the other antenna, ie the antenna 4B, to reversely repeat the described stages, ie the decrease in the set power level to zero. The antenna 4B will therefore be known hereinafter as the "decremental antenna".

If however it is required to reduce the heating power but not to zero, the finger is made to touch or remain on the region of the decremental antenna 4B for the number of touches or time required to reduce the number of lit LEDs or to reduce the number appearing on the 7-segment display unit to that corresponding to the desired power (in the case of LEDs a different number or sign will be associated with each LED to correspond to a given power level).

The programme executed by the microprocessor is, for example and in particular, the following: when the user's finger is applied to the region of the incremental antenna 4A (ie that causing both switching-on of the heating element 3 and the increase in its heating power to the level which the element is required to emit), the output of the relative receiver varies. The microprocessor memory contains the average of readings taken over a time t preceding the application of the finger and converted from analog to digital, as provided both by the incremental antenna 4A and by the decremental antenna 4B. With the application of the finger to the incremental antenna 4A, new analog readings by this antenna reach the microprocessor. These new readings are digitalized and a new average value over a time t is obtained from them. This new average value N is compared with the memorized value and if the comparison shows that it is sufficiently different from that memorized, it is compared with the average value ND which has been memorized in the meantime and obtained from the readings obtained via the decremental antenna 4B over the time t.

If this latter comparison shows that the variation in the average value N is sufficiently different from the variation in ND (this signifying that a request for thermal power is identified), the microprocessor 6 increases the level of this power to the value required by the user, this being displayed by the number of LEDs lit or by the number appearing on the 7-segment display unit, which depends on the time for which the finger remains on the region of the incremental antenna 4A, or on the number of touches by the finger. When maximum possible power is reached, maintaining the finger on the sensitive region obviously does not produce any further increase in thermal power.

Application of the finger to the region of the decremental antenna 4B operates in a conceptually analogous manner. When this occurs, the microprocessor 6 firstly compares the new average value with that previously memorized and, if this comparison shows a sufficient difference, then checks whether the memorized average value relative to the incremental antenna 4A is sufficiently different from the reading by the decremental antenna 4B, and if so the microprocessor 6 decreases the thermal power emitted by the heating element 3.

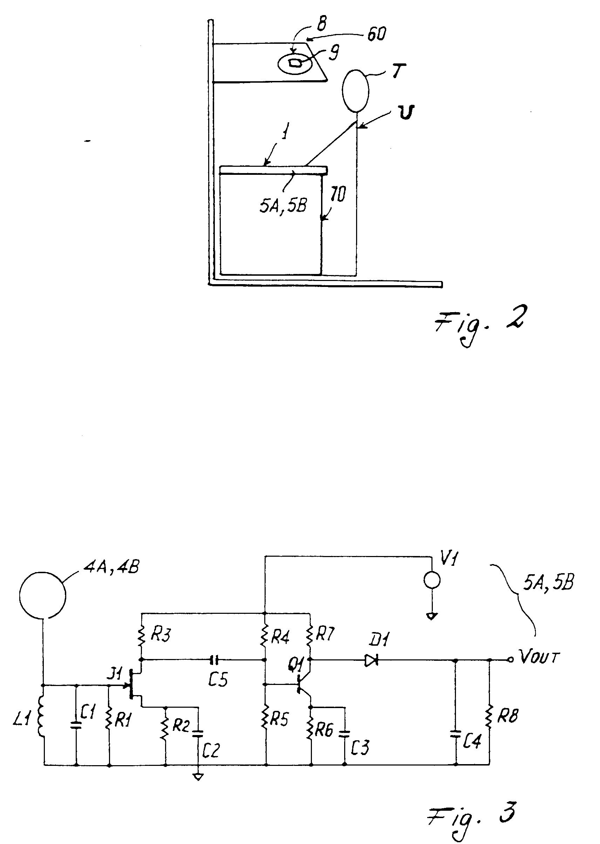

Figure 2 schematically illustrates a different location of the transmitter 9 relative to the cooking hob 1, with the receivers 5A, 5B etc. and the relative antennas being positioned as in Figure 1. Specifically, the transmitter 9 and its antenna 8 are mounted within the hood 60 which generally lies above the appliance 70 provided with the cooking hob 1. With the transmitter positioned in this manner, when the user U approaches the cooking hob 1 (and hence also the hood 60) and places his finger on the area of the chosen receiving antenna, a "wave guide" is created which increases the quantity of signal reaching the receiving antenna. For this wave guide to be effective, ie to produce a variation of a certain extent, the head T of the user U must not be too distant from the radiofrequency source (8, 9).

This means that the system can be sized so that persons below a certain height (such as children) are unable to switch on the cooking hob.

The inventive concept can also be applied to merely switching the appliance functional element (eg. the resistance element) on and off without controlling its operating level. Such an arrangement can also be combined with that heretofore described. In this combination one antenna will have the task of switching on and off, whereas the other two antennas will be used for increasing and decreasing. In the case of simple switching on and off, applying the finger produces a signal change at the receiver output. This signal change can be compared with a reference signal which possibly takes account of the radiofrequency noise present in the environment. To take account of radiofrequency noise (a problem which does not exist in the aforedescribed case of two receivers working as a pair) other already known methods are also possible, for example using a second receiver the only purpose of which is to provide the microprocessor with information regarding the noise level, this information being used as the basis for comparison with the instantaneous signal (due to the presence of the finger).

In the aforegoing embodiments of the invention a corresponding receiver circuit is associated with each antenna, this signifying in the case of the four heating elements of Figure 1 that eight identical receiver circuits are required, or even twelve if a separate receiver circuit is required for simple switching on and off.

By using the multiplexer technique the number of receiver circuits can be reduced to just one as shown schematically in Figure 1A, in which the receiving antennas are indicated by the reference numeral 4 (these can be incremental, decremental or simple on/off). Each antenna is connected to a different input of a conventional multiplexer 40 controlled by the microprocessor 6 via the bus 6B. The output of the multiplexer 40 is connected to a single receiver 5 the output of which passes to the microprocessor 6 which via its control bus 6A operates on the power interface 7.

In elementary terms, the functionality can be explained on the basis of the control of the microprocessor 6. The antennas 4 are connected to the receiver 5 in succession, with each "connection" there corresponding a signal along a corresponding line of the bus 6A. If there is no application or touch of the finger on the antenna which at any given time is connected, then no command reaches the interface 7. If however a receiving antenna is influenced by the finger, then the corresponding line of the bus 6A carries a control signal which can relate to switching on/off or to increase or decrease of the heating power.

Figures 4, 4A show a possible practical embodiment of the device of the invention comprising the use of an electrically conducting tube 50 surrounding each receiving antenna 4. The tube can be of plastics (and hence insulating) material metalized on its outside, or can be formed from an inner insulating layer and an outer conductive layer, or can be entirely of conductive material, in which case the antenna 40, which is of conductive material and surrounded by this tube, will have at least its free end covered with a layer of insulating material. These expedients prevent the antenna undergoing electrical conduction contact, metal against metal, with the tube because of the flexibility of the metal wire antenna. The use of the tube in question has proved to be of considerable use as it provides a focusing action on the energy radiated by the transmitter, this focalization resulting in a limitation in the width of the region in which the finger application provides control action, and a greater variation in the received signal when the finger is correctly applied. In other words, if the tube is absent any involuntary application of the finger of the hand even outside the region X of Figure 4A can result in a false command, whereas because of this surprising focusing effect the control action is obtained only by applying the finger in this region.

The antennas are provided at their free end with an elastically deformable part 51 similar to a conic spring so that they can adhere elastically against the lower face of the insulating plate (or glass ceramic plate 1B) as shown in Figure 4A. The antennas are fixed at their lower end 4D to an insulating board of a printed circuit 52 and are in electrically conductive contact with a conductive strip 53 leading to the receiver, the components of which are fixed to the board 52. The tubes 50 rest lowerly on this board and are inserted into holes 54 provided in another similar board 55 spaced from the first by columns 56. These columns extend beyond the lower board 52 through guide holes 57 provided in the frame 58 supporting the glass ceramic plate 1B.

Between the board 52 and frame 58 there extend compression springs 59 which exert an upward thrust on the assembly, the thrust being limited by heads 57A acting as stops positioned below and acting against the frame.

The upper board 55 carries the transmitting antenna 80 in the form of a printed circuit strip connected to the transmitter, the components of which can be mounted on the upper board 55.

Before mounting the assembly (Figures 4, 4A), the head 51 of the receiving antennas 4 must project a certain distance beyond the upper edge of the tubes 50 so that when mounting is complete these heads rest with a certain force against the plate 1B.

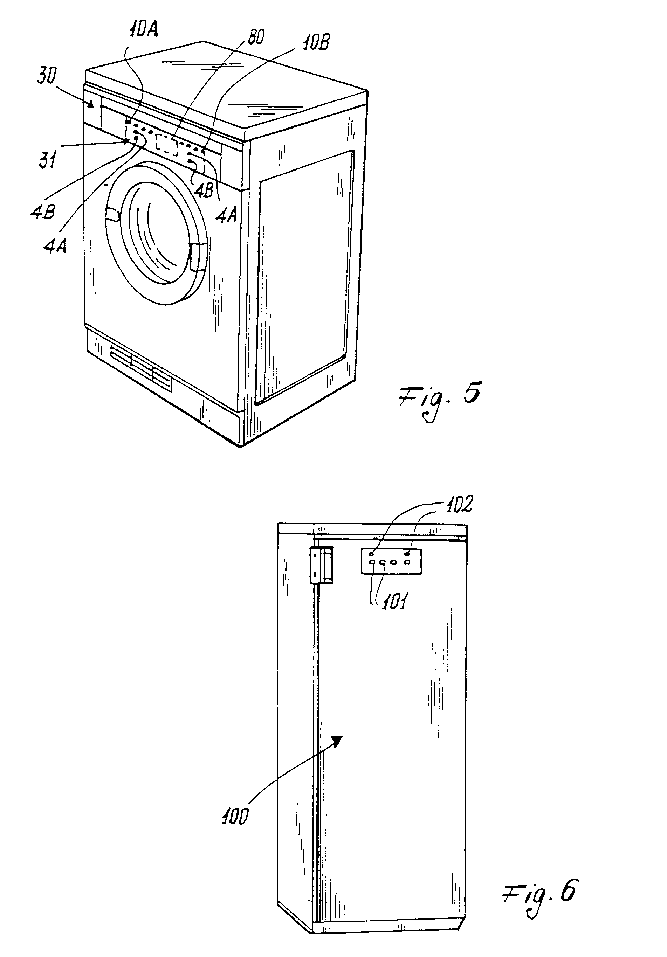

The concept at the basis of the invention can find useful application in other household electrical appliances. For example, in a washing machine or clothes dryer (see Figures 5 and 4) the control panel 30 can be provided with a plate 31 of electrically non-conductive material. On its rear it carries the required number of pairs of radiofrequency receiving antennas for controlling the appliance. In this example two pairs of receiving antennas 4A, 4A and two series of LEDs 10A, 10B are provided.

Each series is associated with one pair of antennas. One pair of antennas serves for example for controlling the spinning rpm on the basis of the type of fabric, whereas the other pair serves for example for controlling the heating power of the conventional resistance element with which this type of appliance is provided.

The appliance will comprise a radiofrequency transmitter the antenna of which is indicated by 80, and receivers to which the antennas 4A, 4B are connected. It will also be provided with a microprocessor and the necessary interfaces. If using a multiplexer as described in relation to Figure 1A, a single receiver will be sufficient.

As shown in Figure 6, the invention can be applied to a refrigerator or freezer. In this case the door 100 carries an insulating plate with a series of LEDs or another display and only two receiving antennas 102, used for example for upwardly and downwardly adjusting the appliance operating temperature. The appliance incorporates the transmitter and receiver or receivers. as will be apparent from the aforegoing the invention can be applied to a resistance heater element and/or microwave oven and to cookers. Both the cooking time and temperature can be controlled in this case.

The meaning of the term "finger" is to be understood in a broad sense, in that the control action can also be exerted by other parts of the user's body, hence the term "finger" as used herein also comprises other parts of the user's body.

## Claims

1. A finger-touch or finger-application control device for household electrical appliances, such as ovens, cooking hobs, cookers, refrigerators, freezers, dishwashers, washing machines, clothes dryers and the like, for controlling at least one functional element thereof, comprising a transmitter (9) with relative antenna (8, 80), at least one receiver (5A, 5B) and a control circuit (6, 7) connected to the receiver (5A, 5B) in order to modify the state of the appliance functional element, wherein the receiver (5A, 5B) comprises an antenna (4A, 4B) which bears against one face of an electrically insulating surface (1, 31), to the other face of which the user's finger can be applied in order to modify the intensity of the signal received by the receiver (5A, 5B), characterized in that the transmitter (9) is a radiofrequency transmitter and in that the receiving antenna (4A,4B) is, at least in part, elastically contractable.

2. A device as claimed in claim 1, characterized by comprising at least two receivers (5A, 5B) with their antennas (4A, 4B) applied to different points of the electrically insulating surface (1, 31), one receiver (5A) being for increasing the state of the functional element (3) and the other (5B) being for decreasing this state.

3. A device as claimed in claim 1 or claim 2, characterized in that the transmitter (9) is positioned relative to the receivers (5A, 5B) on an opposite side of the electrically insulating surface at a distance therefrom such that, when the user (U) approaches the appliance (1) and places his finger on the area of the chosen receiving antenna, a sort of wave guide is created which increases the quantity of signal reaching the receiving antenna.

4. A device as claimed in one or more of the preceding claims, characterized by comprising a) a multiplexer circuit (40) connected to at least two receiving antennas (4) and controlled by a microprocessor or microcontroller (6), and b) a receiver positioned between the output of the multiplexer (40) and the input of the microprocessor or microcontroller (6).

5. A device as claimed in one or more of the preceding claims, characterized in that the receiving antenna (4) is surrounded at a distance by a member (50) which is conductive at least on its outside.

6. A device as claimed in one of the preceding claims, characterized by being used with the household electrical appliances specified in the introduction to claim 1.

7. A device as claimed in claim 1, characterized in that the radiofrequency transmitter (9) has a single antenna (8, 80) and more than one receiver (5A, 5B).

## Patentansprüche

1. Eine durch Fingerberühren oder -anlegen steuerbare Steuereinrichtung für elektrische Haushaltsgeräte, beispielsweise Herde, Kochfelder, Kochgeräte, Kühlgeräte, Gefriergeräte, Geschirrspüler, Waschmaschinen, Wäschetrockner und dergleichen, zur Steuerung mindestens eines Funktionselements dieser Geräte mit einem Sender (9) und zugehörigen Antenne (8, 80), mindestens einem Empfänger (5A, 5B) und einer mit dem Empfänger (5A, 5B) verbundenen Steuerschaltung (6, 7) zur Änderung des Betriebszustands des Funktionselements des Geräts, wobei der Empfänger (5A, 5B) eine Antenne (4A, 4B) aufweist, die gegen eine Fläche eines elektrisch isolierenden Körpers (1, 31) stößt, an dessen andere Fläche der Finger eines Benutzers angelegt werden kann, um die Stärke des durch den Empfänger (5A, 5B) empfangenen Signals zu ändern,
**dadurch gekennzeichnet**,
daß der Sender (9) ein Hochfrequenzempfänger ist und daß die Empfangsantenne (4A, 4B) mindestens teilweise elastisch zusammenziehbar ist.

2. Steuereinrichtung nach Anspruch 1,
dadurch gekennzeichnet,
daß sie mindestens zwei Empfänger (5A, 5B) aufweist, deren Antennen (4A, 4B) an unterschiedliche Punkte des elektrisch isolierenden Körpers (1, 31) angelegt sind, und
daß der eine Empfänger (5A) für die Erhöhung des Betriebszustands des Funktionselements (3) und der andere (5B) für die Verminderung dieses Betriebszustands vorgesehen ist.

3. Steuereinrichtung nach Anspruch 1 oder 2,
dadurch gekennzeichnet,
daß der Sender (9) inbezug auf die Empfänger (5A, 5B) auf der entgegengesetzten Seite des elektrisch isolierenden Körpers mit einem Abstand von diesem Körper derart angeordnet ist, und
daß bei der Annäherung des Benutzers (U) an das Gerät (1) und beim Anlegen des Fingers des Benutzers an die der gewählten Empfangsantenne zugeordnete Fläche eine Art Wellenleitsignal erzeugt wird, das die Größe des die Empfangsantenne erreichenden Signals erhöht.

4. Steuereinrichtung nach einem der vorhergehenden Ansprüche,
gekennzeichnet durch
a) eine Multiplexschaltung (40), die mit mindestens zwei Empfangsantennen (4) verbunden ist und durch einen Mikroprozessor oder eine Mikrosteuerschaltung gesteuert wird, und
b) einen Empfänger, der zwischen dem Ausgang der Multiplexschaltung (40) und dem Eingang des Mikroprozessors (6) oder der Mikrosteuerschaltung angeordnet ist.

5. Steuereinrichtung nach einem der vorhergehenden Ansprüche,
dadurch gekennzeichnet,
daß die Empfangsantenne (4) mit Abstand von einem Glied (50) umgeben ist, das mindestens auf seiner Außenseite leitfähig ist.

6. Steuereinrichtung nach einem der vorhergehenden Ansprüche,
gekennzeichnet durch die Verwendung bei elektrischen Haushaltsgeräten, die im Oberbegriff des Anspruchs 1 genannt sind.

7. Steuereinrichtung nach Anspruch 1,
dadurch gekennzeichnet,
daß der Hochfrequenzempfänger (9) eine einzelne Antenne (8, 80) und mehr als einen Empfänger (5A, 5B) hat.

## Revendications

1. Dispositif de commande par application ou contact d'un doigt destiné à des appareils électroménagers tels que les fours, les plaques de cuisson, les cuiseurs, les réfrigérateurs, les congélateurs, les lave-vaisselle, les lave-linge, les sèche-linge et analogues, pour la commande d'au moins un élément fonctionnel de tels appareils, comprenant un émetteur (9) ayant une antenne relative (8, 80), au moins un récepteur (5A, 5B) et un circuit de commande (6, 7) connecté au récepteur (5A, 5B) pour la modification de l'état de l'élément fonctionnel de l'appareil électroménager, dans lequel le récepteur (5A, 5B) comporte une antenne (4A, 4B) qui est en appui contre une face d'une surface électriquement isolante (1, 31), le doigt de l'utilisateur pouvant être appliqué à l'autre face pour modifier l'intensité du signal reçu par le récepteur (5A, 5B), caractérisé en ce que l'émetteur (9) est un émetteur à hautes fréquences et en ce que l'antenne réceptrice (4A, 4B) est au moins en partie élastiquement contractible.

2. Dispositif selon la revendication 1, caractérisé en ce qu'il comprend au moins deux récepteurs (5A, 5B) dont les antennes (4A, 4B) sont appliquées en des points différents de la surface isolante de l'électricité (1, 31), un premier récepteur (5A) étant destiné à augmenter l'état de l'élément fonctionnel (3) et l'autre (5B) à réduire cet état.

3. Dispositif selon la revendication 1 ou 2, caractérisé en ce que l'émetteur (9) est positionné par rapport aux récepteurs (5A, 5B) du côté opposé de la surface électriquement isolante à une distance de celle-ci telle que, lorsque l'utilisateur (U) s'approche de l'appareil (1) et place son doigt sur la zone de l'antenne réceptrice choisie, une sorte de guide d'onde est créé et augmente la quantité du signal atteignant l'antenne réceptrice.

4. Dispositif selon l'une ou plusieurs des revendications précédentes, caractérisé en ce qu'il comprend a) un circuit multiplexeur (40) connecté à au moins deux antennes réceptrices (4) et commandé par un microprocesseur ou un microcontrôleur (6), et b) un récepteur positionné entre la sortie du multiplexeur (40) et l'entrée du microprocesseur ou microcontrôleur (6).

5. Dispositif selon l'une ou plusieurs des revendications précédentes, caractérisé en ce que l'antenne réceptrice (4) est entourée à une certaine distance par un organe (50) qui conduit au moins à l'extérieur.

6. Dispositif selon l'une quelconque des revendications précédentes, caractérisé en ce qu'il est utilisé avec les appareils électroménagers spécifiés dans l'introduction de la revendication 1.

7. Dispositif selon la revendication 1, caractérisé en ce que l'émetteur à hautes fréquences (9) possède une antenne unique (8, 80) et plusieurs récepteurs (5A, 5B).
